# EUROPÄISCHE PATENTSCHRIFT

(11) **EP 2 042 260 B1**
(45) Veröffentlichungstag und Bekanntmachung des Hinweises auf die Patenterteilung: **18.12.2013**
(21) Anmeldenummer: 08016620.0
(22) Anmeldetag: 22.09.2008
(51) Int. Cl.: B23K 35/34, B22F 1/00, B23K 35/30, B23K 35/02, H01L 23/00

(54) **Verfahren und Paste zur Kontaktierung von Metallflächen**
Method and paste for contacting metal surfaces
Procédé et pâte de contact de surfaces métalliques

(30) Priorität: 28.09.2007 DE 102007046901; 08.07.2008 DE 102008031893
(43) Veröffentlichungstag der Anmeldung: 01.04.2009
(73) Patentinhaber: Heraeus Materials Technology GmbH & Co. KG, 63450 Hanau (DE)
(72) Erfinder: Schmitt, Wolfgang, 63110 Rodgau (DE); Dickel, Tanja, 63543 Neuberg (DE); Stenger, Katja, 63831 Wiesen (DE)
(74) Vertreter: Kühn, Hans-Christian

(56) Entgegenhaltungen:
- WO-A1-2004/026526
- DE-A1-102005 053 553
- US-A1- 2003 108 664
- US-B2- 6 951 666

## Beschreibung

Die vorliegende Erfindung betrifft ein Verfahren zur Herstellung einer elektrisch leitfähigen oder wärmeleitfähigen Verbindung zur Kontaktierung zweier Elemente.

Zur Sandwichbauweise aneinander zu fügender elektronischer Bauteile werden Kontaktierungspasten aus in Lösungsmittel dispergierten Silberflocken (Silberflakes) unter Druck in der Größenordnung von 30 MPa bei Temperaturen von ungefähr 300°C gesintert, um eine dünne Schicht von ungefähr 50 µm auf ein elektronisches Bauteil (Chip) aufzutragen. Hierbei wird eine zuverlässige Verbindung von Chip und Substrat geschaffen, die Betriebstemperaturen von über 250°C standhält. Die zu verbindenden Flächen müssen edel sein, insbesondere aus Silber oder Gold bestehen.

WO 2004/026526 offenbart die Anwendung von Nanosilber mit Partikelgrößen < 100 nm, um den Druck auf etwa 20 MPa und die Temperatur auf ca. 250°C herabzusetzen.

Nach US 6,951,666 werden leicht zersetzbare Silberverbindungen in Pasten zur Erstellung von Siebdrucken angewendet, beispielsweise zusammen mit Silberflocken oder Nanosilber oder einer Kombination aus Silberflocken und Nanosilber.

Aus der Offenbarung US2003/108664 A1 sind Pasten zur Erzeugung leitfähiger Muster auf einem Substrat bekannt, die leicht zersetzliche Silberverbindungen enthalten.

Die Aufgabe der vorliegenden Erfindung liegt darin, einerseits Kontaktierungen bereitzustellen, die einen Schmelzpunkt möglichst weit oberhalb eines Weichlots aufweisen und andererseits aber möglichst einfach wie mit Weichlot herstellbar sind. Es sollen elektronische Bauteile mit einem Temperaturanwendungsbereich, der sich bis über 200°C und gegebenenfalls sogar über 250°C erstreckt, leichter auf Substraten befestigt werden, insbesondere dafür die Druckbelastung verringert werden. Hierfür soll ein geeignetes Kontaktierungsverfahren bereitgestellt werden.

Die Aufgabe wird durch die Erfindung, so wie sie in Anspruch 1 definiert ist, gelöst.

Zur Lösung der Aufgabe werden lose Bauteile mittels Kontaktpaste weit unterhalb des Schmelzpunktes des Metalls, mit dem die Befestigung erfolgt, vollflächig aneinander befestigt.

Die Lösung der Aufgabe erfolgt mit den Merkmalen der unabhängigen Ansprüche. Bevorzugte Ausführungen sind in den abhängigen Ansprüchen beschrieben.

Zur Herstellung einer elektrisch leitfähigen oder einer wärmeleitfähigen Verbindung zur stabilen Kontaktierung zweier loser Elemente, insbesondere eines elektronischen Bauteils mit einem weitem Bauteil wird erfindungsgemäß eine Metall-, insbesondere Silberverbindung zu elementarem Metall, insbesondere Silber zwischen den Kontaktflächen umgesetzt. Hierzu reichen bereits unedle Metallisierungen wie z.B. Kupfermetallisierungen an den Bauteilen aus um einen festen Kontakt zwischen den Bauteilen herzustellen.

Beim Zusammenfügen zweier sandwichartig zu verbindender elektronischer Bauteile mittels einer elektrisch leitfähigen oder einer wärmeleitfähigen Verbindung zur Kontaktierung der Bauelemente ermöglicht das Zersetzen einer Metallverbindung, insbesondere Silberverbindung, zu elementarem Metall, insbesondere Silber zwischen den Kontaktflächen der Bauelemente eine erhebliche Reduzierung von Druck und Temperatur, um die Bauteile miteinander zu versintern. Das sandwichartige Zusammenfügen erfolgt der Einfachheit halber in einem Ofen oder mittels Heizplatte, insbesondere in einem Umluftkammertrockenschrank oder einem Durchlaufofen mit Heizplattensystemen oder mittels beheizbarem Stempel.

Maßgeblich für die vorliegende Erfindung ist, dass die sandwichartige Kontaktierung der Bauteile deren mechanische Befestigung aneinander ist, die vorzugsweise zusätzlich als Wärmeleitung genutzt wird oder als elektrische Verbindung.

Vorzugsweise
- ist die Metallverbindung, insbesondere Silberverbindung eine organische Metallverbindung, insbesondere Silberverbindung wie Silbercarbonat oder Silberoxid;
- weist eine Kontaktfläche unedles Metall in der Oberfläche auf;
- liegt die Prozesstemperatur zur Herstellung des Silberkontakts unterhalb von 400°C, insbesondere zwischen 150° und 350°C;
- erfolgt die Herstellung des Silberkontakts unter Atmosphärendruck;
- wird eine Paste, die die Silberverbindung aufweist, auf eine Kontaktfläche aufgetragen;
- ist der Metallkontakt eine einheitliche Schicht.

Die Paste enthält vorzugsweise ein Gel gemäß DE 10 2005 053 553 A1 und Kupfer- oder Silberpartikel, insbesondere im Bereich zwischen 0,2 µm und 5 µm, besonders bevorzugt zwischen 0,5 µm und 2 µm.

Metallverbindungen, insbesondere Silberverbindungen, die sich unter 300°C, insbesondere unter 250°C zersetzen und dabei elementares Metall, insbesondere Silber bildern, sind besonders geeignet, Sinterpasten bezüglich ihrer Anwendung zwischen 200° bis 300°C erheblich zu verbessern. Für das erfindungsgemäße Verfahren werden Kontaktierungspasten bereitgestellt, die leicht zersetzbare Silberverbindungen aufweisen. Diese Pasten ermöglichen ein Kontaktieren bei niederem Anpressdruck, insbesondere unter 5 bar, vorzugsweise unter 3 bar und eine Prozesstemperatur von ca. 230°C, d. h. unter 250°C, insbesondere unter 240°C.

Die erfindungsgemäße Kontaktierung zwischen den Oberflächen ist bei über 200°C temperaturwechselbeständig, und zwar über 2.000 Zyklen. Damit übertrifft die Kontaktierungspaste die mit Weichlotlegierungen oder Leitklebern erzielbare Temperaturbeständigkeit und Temperaturwechselbeständigkeit. Im Rahmen der vorliegenden Erfindung wird es somit ermöglicht, dass die Kontaktierungstemperatur der Kontaktierungspaste unter der Betriebstemperatur der mit der Paste hergestellten Kontakte liegt. Dies vereinfacht die Verfahren zur Herstellung sandwichartiger Module aus elektronischen Bauteilen. Die erfindungsgemäß leicht zersetzlichen Silberverbindungen sind einfacher herstellbar und leichter zu konservieren als Nanosilber. Nanosilber verliert während der Lagerung die gewünschten Eigenschaften, da die Oberfläche sich durch Agglomeration ständig verkleinert und somit zum Fügen nicht mehr geeignet ist.

Maßgeblich ist, dass die Paste neben ihren organischen Bestandteilen wie Lösungsmittel und/oder Carbonsäuren eine leicht zersetzliche Metallverbindung, insbesondere Silberverbindung aufweist, durch die eine Verarbeitung wie mit Weichlot unter 400°C ermöglicht wird. Vorzugsweise bildet die Silberverbindung unter 300°C, insbesondere unter 250°C, metallisches Silber. Geeignete Silberverbindungen sind Silberoxid, Silbercarbonat und insbesondere organische Silberverbindungen. Besonders bewährt hat sich Silberlaktat.

Es wird vermutet, dass die erfindungsgemäßen Pasten und Verfahren auf der Bildung von hochreaktivem in situ erzeugtem Metall, insbesondere Silber beruhen, das die Kontaktflächen und die gegebenenfalls in der Paste vorliegenden Feststoffe miteinander verbindet. Dabei scheint es möglich, dass das aus der zersetzten Metallverbindung entstandene Metall zuerst eine reaktive Kornoberfläche auf den Feststoffen bildet, die später leicht versintert oder dass das aus der Metallverbindung entstehende Metall sofort die Korngrenzen miteinander verbindet. Insofern ist für den Verbindungsmechanismus gemäß der vorliegenden Erfindung nicht geklärt, ob es sich hauptsächlich um ein Versintern, Verkleben oder Verdichten handelt. Auf jeden Fall wird die mechanische Festigkeit der Kontaktstelle durch die Zersetzung der Metallverbindung erhöht und deren Porosität verringert, insbesondere um 1 bis 20 %.

Leicht zersetzbare Silberverbindungen sind in bekannten Pasten, beispielsweise zusammen mit Silberflocken oder Nanosilber oder einer Kombination aus Silberflocken und Nanosilber anwendbar. In einer weiteren bevorzugten Ausführung wird eine Paste mit einer leicht zersetzlichen Silberverbindung und Kupferpulver bereitgestellt. Die Teilchengröße des Kupferpulvers beträgt vorzugsweise unter 10 µm.

Übliche Kontaktfächen der Bauteile sind Metallisierungen aus Edelmetall oder mit einer Edelmetallbeschichtung. Die Paste eignet sich weiterhin zur Verbindung von unedlen Metalloberflächen, beispielsweise Kupferoberflächen.

Erfindungsgemäß wird neben Silberoberflächen auch auf Kupfer- und Nickel-Gold-Oberflächen eine feste Verbindung mit sehr guter elektrischer Leitfähigkeit schon bei ungefähr 230°C gesintert. Die Zugbelastung der Verbindungen beträgt ungefähr 50 MPa.

Die für die Erfindung eingesetzten Pasten eignen sich für die Befestigung von Kohlkörpern oder LED's sowie die Anwendung in der Optoelektronik und Leistungselektronik (Power-Module), insbesondere DCB (Direct Copper Bonding) und Die-Attach.

Vorzugsweise ist die Kontaktierungspaste harzfrei. Insbesondere wird ein Gel gemäß DE 10 2005 053 553 A1 mit einer leicht zersetzbaren Silberverbindung und gegebenenfalls noch mit einem Metallpulver wie Silberflakes, Nanosilber oder Kupferpulver gemischt.

Erfindungsgemäß wird eine Niedertemperatur Sintertechnik (NTV) geschaffen, die die Bond-draht-Technik zurückdrängen wird, da das beidseitige Erwärmen von Bauteilen mit der Sinterpaste von Vorteil ist.

Erfindungsgemäß wird es ermöglicht, dass die Paste anstatt mit Siebdruck mittels Dispensen und insbesondere Schablonendruck oder ein Sprühverfahren aufgetragen wird.

Im Folgenden wird die Erfindung anhand von Beispielen mit Bezug auf die Abbildungen verdeutlicht.
- Abb. 1: zeigt die vollflächige Befestigung von LED's auf einem Kühlkörper;
- Abb. 2: zeigt die vollflächige Befestigung eines elektronischen Bauteils (Chip) auf einer Leiterbahn;
- Abb. 3: zeigt die vollflächige Befestigung eines DCB auf einem Kühlkörper;
- Abb. 4: zeigt die Befestigung eines Si-Halbleiters auf einem Cu-Substrat;
- Abb. 5: zeigt die elektrische, thermische und mechanische Verbindung eines Halbleiters (z.B. Si oder GaAs) mit einem anderen Halbleiter, z.B. (Si oder GaAs) (= Stacked Die);
- Abb. 6: zeigt die elektrische, thermische und mechanische Verbindung eines Halbleiters auf einer Metallisierung (Flip Chip);
- Abb. 7: zeigt die elektrische, thermische und mechanische Verbindung eines elektronischen Bauteils mit einem anderen elektronischen Bauteil, wobei das eine Bauteil auf dem anderen Bauteil befestigt wird (Package on Package/PoP);
- Abb. 8: zeigt die elektrische, thermische und mechanische Verbindung einer Solarzelle, auf einem Substrat oder Kohlkörper aus Metall, Keramik oder Kunststof.

Die Kontaktierung erfolgt jeweils zwischen den dafür vorgesehenen Metallisierungen der Bauteile. Diese den Metallkontakt begrenzenden Metallisierungen sind in den Abbildungen nicht aufgeführt da sie im Fall eines Silberkontakts zwischen Silbermetallisierungen oder Kupferkontakts zwischen Kupfermetallisierungen im Kontakt untergegangen sind.

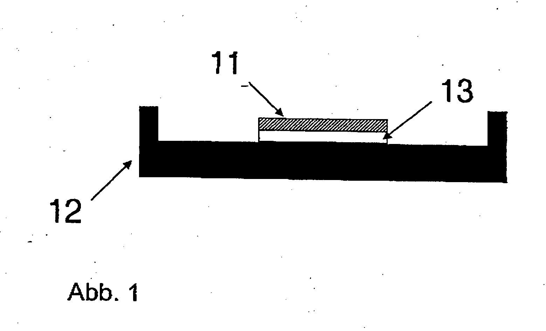

Gemäß einer Ausführung nach Abb. 1 ist ein LED 11 auf einem Kühlkörper 12 mit einer Kontaktierung 13 befestigt.

Die Wärmeentwicklung des LED 11 birgt bei Weichlotkontakten die Gefahr zur Versprödung durch Ausbildung intermetallischer Phasen und beeinträchtigt somit die Zuverlässigkeit der Kontakte.

Mit einer Kontaktierungspaste aus einem Gel gemäß DE 10 2005 053 553 A1, in dem Silberlaktat neben Silberflocken (Flakes) dispergiert ist, wird ein reiner Silberkontakt hergestellt, der naturgemäß die beste Wärmeleitfähigkeit aufweist und unter der Dauertemperaturbelastung des LED's keine Alterung zeigt.

Zur Herstellung einer LED-Befestigung nach Abb. 1 wird eine Paste aus 80 Gew.-% Silber, 5 Gew.-% Silberlaktat und 15 Gew.-% Gel gemäß DE 10 2405 053 553 A1 vollflächig auf den losen Kühlkörper 12 aufgetragen. Dann wird der lose LED 11 auf die Paste gesetzt und der Rohling im Ofen 45 bis 60 Minuten auf 230°C erhitzt. Der dabei erzeugte Silberkontakt 13 ist der bestmögliche Wärmeleiter, mit uneingeschränkter Zuverlässigkeit für die LED-Anwendung. Der Kontakt 13 ist für weitaus höhere Temperaturen beständig.

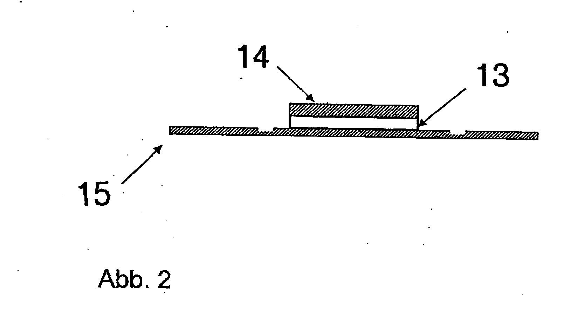

Gemäß einer Ausführung nach Abb. 2 ist ein Hochtemperatursensor 14 gemäß EP 0 809 094 A1 der Heraeus Sensor Technology GmbH auf einem Leiterrahmen15 mit einer Kontaktierung 13 befestigt. Die Hochtemperaturanwendung des Hochtemperatursensors 14, dessen Anwendungsbereich über 500°C reicht, wäre bei Weichlotkontakten auf die Schmelztemperatur des Weichlots beschränkt, wobei die Versprödung durch Ausbildung intermetallischer Phasen die Einsatzdauer der Kontakte begrenzen würde.

Mit einer Kontaktierungspaste aus einem Gel gemäß DE 10 2005 053 553 A1, in dem Silbercarbonat neben Silberflocken (Flakes) dispergiert ist, wird ein reiner Silberkontakt hergestellt, der naturgemäß die beste elektrische Leitfähigkeit aufweist und bei den angewendeten Temperaturen des Sensors absolut zuverlässig ist.

Zur Herstellung einer Chip-Kontaktierung nach Abb. 2 wird eine Paste aus 80 Gew.-% Silber, 5 Gew.-% Silbercarbonat und 15 Gew.-% Gel gemäß DE 10 2005 053 553 A1 auf den Leiterrahmen 15 aufgetragen. Dann wird der Chip 14 auf die Paste gesetzt und der Rohling im Ofen 30 bis 60 Minuten auf 260 bis 270°C erhitzt. Der dabei erzeugte Silberkontakt 13 ist der bestmögliche elektrische Leiter mit der gewünschten Zuverlässigkeit für die Sensoranwendung.

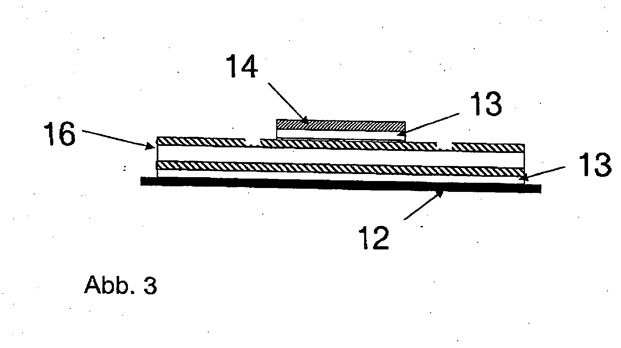

Gemäß einer Ausführung nach Abb. 3 ist ein DCB 6 elektrisch mit einem Chip 14 und wärmeleitend auf einem Kühlkörper 12 mit je einer Kontaktierung 13 befestigt. Die Wärmeentwicklung des Chips 4 birgt bei Weichlotkontakten die Gefahr zur Versprödung durch Ausbildung intermetallischer Phasen und beeinträchtigt somit die Zuverlässigkeit der Kontakte 13.

Mit einer Kontaktierungspaste aus einem Gel gemäß DE 10 2005 053 553 A1, in dem Silberlaktat neben Silberflocken und Kupferflocken dispergiert ist, wird für die Kontaktierung des DCB mit dem Kühlkörper ein reiner Metallkontakt hergestellt, der eine sehr gute Wärmeleitfähigkeit aufweist und unter der Dauertemperaturbelastung des Chips keine Alterung zeigt.

Mit einer Kontaktierungspaste aus einem Gel gemäß DE 10 2005 053 553 A1, in dem Silberlaktat neben Silberflocken dispergiert ist, wird für die Kontaktierung des DCB mit dem Chip ein reiner Metallkontakt hergestellt, der eine sehr gute elektrische Leitfähigkeit aufweist und unter der Dauertemperaturbelastung des Chips keine Alterung zeigt.

Zur Herstellung von DCB-Kontakten nach Abb. 3 wird eine Paste aus 60 Gew.-% Kupfer, 20 Gew.-% Silber, 5 Gew.-% Silberlaktat und 15 Gew.-% Gel gemäß DE 10 2005 053 553 A1 auf den Kühlkörper 12 aufgetragen. Dann wird der DCB 16 auf die Paste gesetzt und mit einer Paste aus 80 Gew.-% Silber, 5 Gew.-% Silberlaktat und 15 Gew.-% Gel gemäß DE 10 2005 053 553 A1 beschichtet, worauf der Chip 14 gesetzt wird und dieser Rohling bei einem isostatischem Druck von 2 bis 3 bar im Ofen 20 bis 40 Minuten auf 240°C erhitzt wird. Der dabei erzeugte Silberkontakt 13 ist der bestmögliche elektrische Leiter mit uneingeschränkter Zuverlässigkeit für die Chip-Anwendung. Der Kupfer-Silber-Kontakt 13 ist zuverlässig für eine sehr gute Wärmeübertragung.

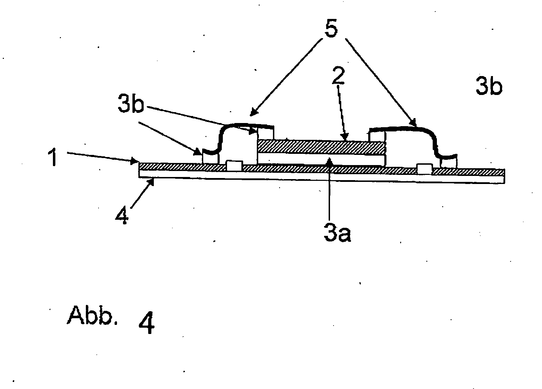

Abb. 4 zeigt die Befestigung eines LED oder Si-Halbleiters 2 auf einer Leiterbahn 1, mit einer erfindungsgemäß hergestellten Silberschicht 3. Der Chip 2 ist elektrisch über Bändchen 5 mit der Bahn verbunden, die ebenfalls mit Silberschichten 3 befestigt sind. Leiterbahnen und Bändchen aus Kupfer oder Silber haben sich bewährt, insbesondere auf einem elektrisch isolierenden Trägersubstrat fixierte Leiterbahnen.

Mit einer Kontaktierungspaste aus einem Gel gemäß DE 10 2005 053 553 A1, in dem Silberlaktat neben Silberflocken (Flakes) dispergiert ist, wird ein reiner Silberkontakt 3 hergestellt, der naturgemäß die beste Wärmeleitfähigkeit aufweist und unter Dauertemperaturbelastung des Chips 2 oder LED's keine Alterung zeigt.

Zur Herstellung des Silberkontakts haben sich Umluftkammertrockenschränke oder Durchlauföfen mit Heizplattensystemen oder Stempel (wie Flipchip-Bonder oder Die Bonder) jeweils mit regelbarem Temperaturprofil unter folgenden Betriebsbedingungen bewährt:
Temperaturprofil während der Kontaktierung;
Aufheizgeschwindigkeit ≥ 0,5 K/s;
Endtemperatur 230 - 400°C,
Prozesszeit vom Aufheizen bis zum Abkühlen 5 - 60 min
Ofenatmosphäre: Luft oder Stickstoff (Restsauerstoffgehalt > 1000 ppm) oder Formiergas (Restsauerstoffgehalt > 1000 ppm) oder Vakuum > 10 mbar (Restsauerstoffgehalt > 100 ppm)

Bei einer Aufheizrate unter 0,3 K/s oder einer Endtemperatur unter 200 oder einer Hitzebehandlung unter 5 Minuten oder einem Vakuum unter 10 mbar erfolgt keine brauchbare Verfestigung, so dass keine belastbare Silberschicht erhalten wird.

Die Höhe der Endtemperatur wird durch die Temperaturempfindlichkeit der Bauteile bestimmt. Luftatmosphäre ist die bevorzugte Sinteratmosphäre. Stickstoff oder Formiergas dienen dem Schutz der Cu-Substratoberfläche vor Oxidation. Vakuum, insbesondere zwischen 100 und 300 mbar vermeidet zusätzlich Lufteinschlüsse.

Zur Herstellung einer Si-Chip-Befestigung nach Abb. 4 wird eine Paste aus 80 Gew.-% Silber, 5 Gew.-% Silberlaktat und 15 Gew.-% Gel gemäß DE 10 2005 053 553 A1 auf ein strukturiertes 2 mm dickes und 10 mm breites Cu-Substrat 1 aufgetragen. Dann wird der Chip auf die Paste gesetzt und der Rohling im Ofen 45 bis 60 Minuten auf 230°C erhitzt. Der dabei erzeugte Silberkontakt 3 ist der bestmögliche Wärmeleiter, mit uneingeschränkter Zuverlässigkeit für die Chip-Anwendung. Der Kontakt 3 ist für weitaus höhere Temperaturen als 230 °C beständig.

Mit einer Kontaktierungspaste aus einem Gel gemäß DE 10 2005 053 553 A1, in dem Silberlaktat neben Silberflocken und Kupferflocken dispergiert ist, wird für die Kontaktierung des Chips mit der DCB ein reiner Metallkontakt hergestellt, der eine sehr gute Wärmeleitfähigkeit aufweist und unter der Dauertemperaturbelastung des Leistungsmoduls keine Alterung zeigt. Dieser Kontakt ist besonders aufgrund der hohen Stromdichten bei DCB-Anwendungen besser geeignet als ein reiner Silberkontakt.

Analog zum Beispiel gemäß Abb. 4 wird für die Beispiele gemäß Abb. 2, 3, 4 und 5 mit einer Kontaktierungspaste aus einem Gel gemäß DE 10 2005 053 553 A1, in dem Silbercarbonat neben Silberflocken (Flakes) dispergiert ist, ein reiner Silberkontakt hergestellt, der naturgemäß auch die beste elektrische Leitfähigkeit aufweist und bei den angewendeten Temperaturen des Sensors absolut zuverlässig ist.

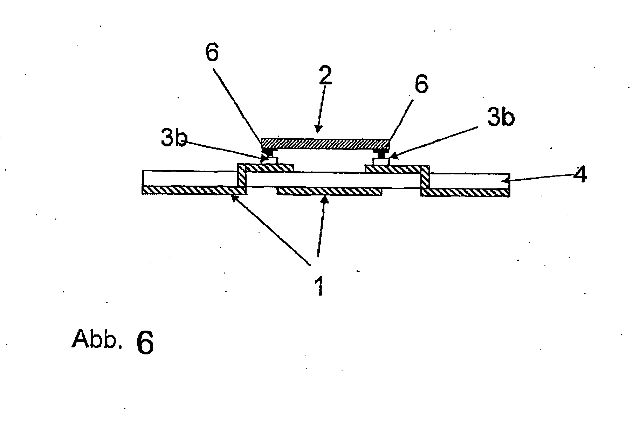

Analog zu Abb. 4 wird zur Herstellung einer Chip-Kontaktierung nach Abb. 6 bis 8 eine Paste aus 80 Gew.-% Silber, 5 Gew.-% Silbercarbonat und 15 Gew.-% Gel gemäß DE 10 2005 053 553 A1 auf den Leiterrahmen 1 aufgetragen, der gegebenenfalls auf einem elektrisch isolierenden Substrat 4 fixiert ist. Dann wird der Chip 2 auf die Paste gesetzt und der Rohling im Ofen 30 bis 60 Minuten auf 260°C bis 270°C erhitzt. Der dabei erzeugte Silberkontakt 3 ist der bestmögliche elektrische Leiter mit der gewünschten Zuverlässigkeit für die Sensoranwendung.

Mit einer Kontaktierungspaste aus einem Gel gemäß DB 10 2005 053 553 A1, in dem Silberlaktat neben Silberflocken dispergiert ist, wird für die Kontaktierung des Silberbändchens mit dem Chip ein reiner Metallkontakt hergestellt, der eine sehr gute elektrische Leitfähigkeit aufweist und unter der Dauertemperaturbelastung des Chips keine Alterung zeigt.

Analog zu Abb. 4 sind die Silberkontakte 3 in den Abbildungen 6 bis 8 mit 3a für vollflächige Wärmeübertragungskontakte und mit 3b für elektrische Kontakte bezeichnet.

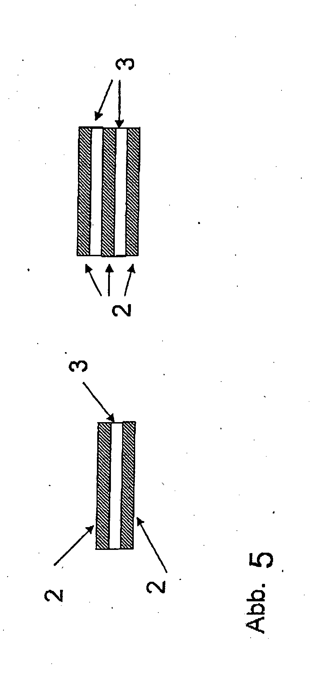

Abb. 5 zeigt die elektrische, thermische und mechanische Verbindung eines Halbleiters, z.B. Si oder GaAs mit einem anderen Halbleiter, z.B. Si oder GaAs (= Stacked Die). Dieses Schema gilt sowohl für Halbleiter, deren Vorderseiten miteinander verbunden werden oder wobei die Rückseite des einen Bauteils (Back end) mit der Oberseite des anderen Bauteils verbunden wird (Front end).

Nach Abb. 6 sind die Vorderseiten der Halbleiter 2 über Bumps 6 aus Cu, Ag oder Au mit einem Silberkontakt 3b auf einer Metallisierung fixiert, wobei die Metallisierung elektrisch mit der Kupferbahn 1 verbunden ist (Flip Chip).

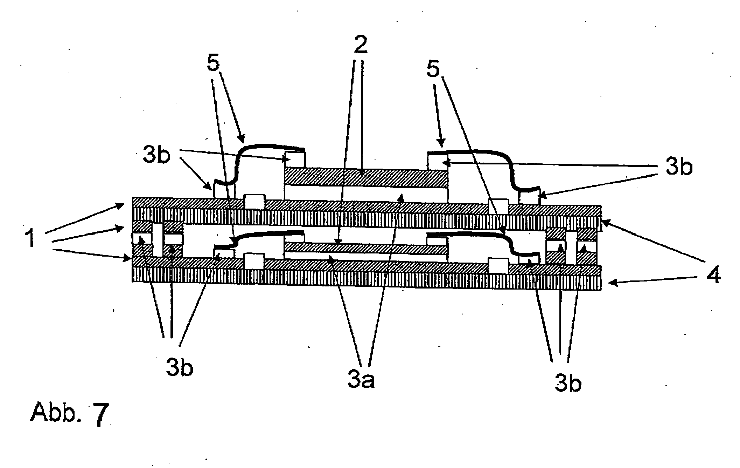

In Abb. 7 ist die elektrische, thermische und mechanische Verbindung 3 eines elektronischen Bauteils gemäß Abb. 1 mit einem weiteren elektronischen Bauteil gemäß Abb. 1 dargestellt, wobei das eine Bauteil auf dem anderen Bauteil befestigt wird (Package on Package / PoP). Die Bauteile werden erfindungsgemäß nicht mehr nach der Herstellung der einzelnen Bauteile miteinander verbunden, sondern es werden bereits bei der Herstellung der Silberkontakte 3 der Bauteile auch die Silberkontakte 3 zur Befestigung der Bauteile aneinander hergestellt.

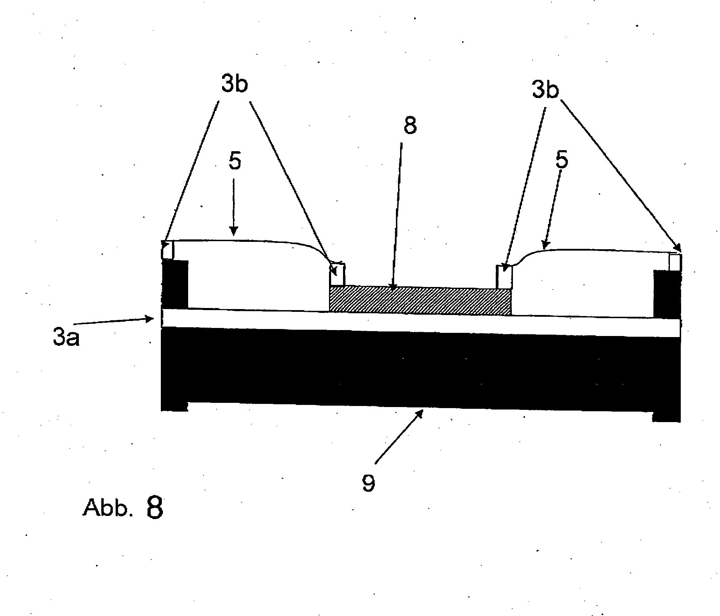

In Abb. 8 ist die elektrische, thermische und mechanische Verbindung 3a einer Solarzelle 8 auf einem Substrat oder Kühlkörper 9 aus Metall, Keramik oder Kunststoff dargestellt. Die Kühlung der Solarzelle 8 ist erheblich für deren Leistung und Lebensdauer, da die Betriebstemperatur einer Solarzelle 8 durchaus über der Herstellungstemperatur des Silberkontakts 3a liegen kann, mit dem die Solarzelle 8 auf dem Kühlkörper 9 befestigt ist.

Insbesondere bei Solarzellen ist eine zuverlässige elektrische, thermische und mechanische Verbindung 3 eines elektrischen Bauelementes mit anderen Bauelementen der gleichen Funktionalität oder anderer elektrischer oder elektronischer Funktionalität erforderlich. Die in Serie angeordneten Solarzellen 8 sind elektrisch über Silberkontakte 3b und Silber oder Kupferbändchen an Metallkontakte angeschlossen, um den in den Solarzellen 8 erzeugten elektrischen Strom abzuführen.

## Patentansprüche

1. Verfahren zur Herstellung einer elektrisch leitfähigen oder wärmeleitfähigen Verbindung zur Kontaktierung zweier Elemente, **dadurch gekennzeichnet, dass** aus einer Silberverbindung elementares Silber zwischen übereinander stehenden Kontaktflächen gebildet wird.

2. Verfahren nach Anspruch 1, **dadurch gekennzeichnet, dass** die Silberverbindung eine organische Silberverbindung, Silberoxid oder Silbercarbonat ist.

3. Verfahren nach Anspruch 1 oder 2, **dadurch gekennzeichnet, dass** die organische Silberverbindung Silberlaktat ist.

4. Verfahren nach einem der Ansprüche 1 bis 3, **dadurch gekennzeichnet, dass** eine Kontaktfläche unedles Metall in der Oberfläche aufweist.

5. Verfahren nach einem der Ansprüche 1 bis 4, **dadurch gekennzeichnet, dass** die Verfahrenstemperatur zur Herstellung der Kontaktierung unterhalb von 400°C liegt.

6. Verfahren nach einem der Ansprüche 1 bis 5, **dadurch gekennzeichnet, dass** eine Paste, die die Silberverbindung aufweist, auf eine Kontaktfläche aufgetragen wird.

7. Verfahren zur Herstellung eines vollflächigen Metallkontakts zwischen einer metallischen Anschlussfläche eines elektronischen Bauteils und einer metallischen Anschlussfläche eines weiteren Bauteils zur Befestigung der Bauteile aneinander bei einer Temperatur unter 400°C, nach einem der Ansprüche 1 bis 6, **dadurch gekennzeichnet, dass** dabei ein Metallkontakt hergestellt wird, der aus einem Metall besteht, das erst über 400°C schmilzt, indem eine Verbindung dieses Metalls oder einer Komponente davon unter 400°C in das Metall oder eine Komponente davon zersetzt wird.

8. Verfahren nach einem der Ansprüche 1 bis 7, **dadurch gekennzeichnet, dass** die Kontaktierung zweier Bauteile die Befestigung
a) von Kühlkörpern oder LEDs oder DCBs oder Solarzellen; oder
b) Si-Halbleitern auf einem Cu-Substrat; oder
c) zu Flip Chip oder Package on Package (PoP)
ist.

9. Verwendung einer Kontaktpaste, enthaltend eine unter 400°C zersetzliche Metallverbindung zum vollflächigen Befestigen loser Bauteile an lose elektrische Bauteile.

## Claims

1. Method for producing an electrically-conductive or heat-conductive connection for contacting two elements, **characterised in that** elemental silver is formed from a silver compound to be situated between contact surfaces that are situated above each other.

2. Method according to claim 1, **characterised in that** the silver compound is an organic silver compound, silver oxide or silver carbonate.

3. Method according to claim 1 or 2, **characterised in that** the organic silver compound is silver lactate.

4. Method according to any one of the claims 1 to 3, **characterised in that** one contact surface comprises non-noble metal in its surface.

5. Method according to any one of the claims 1 to 4, **characterised in that** the process temperature for producing the contacting is below 400°C.

6. Method according to any one of the claims 1 to 5, **characterised in that** a paste comprising said silver compound is being applied to a contact surface.

7. Method for producing a full-surface metal contact between a metallic connecting surface of an electronic component and a metallic connecting surface of another component for attaching the components to each other at a temperature below 400°C, according to any one of the claims 1 to 6, **characterised in that**, in the process, a metal contact is generated that consists of a metal that melts no earlier than above 400°C, **in that** a compound of said metal or of a component thereof is decomposed below 400°C to form the metal or a component thereof.

8. Method according to any one of the claims 1 to 7, **characterised in that** the contacting of two components is the attachment
a) of cooling elements or LEDs or DCBs or photovoltaic cells, or
b) Si semi-conductors on a Cu substrate, or
c) on flip chip or package on package (PoP).

9. Use of a contact paste containing a metal compound that can be decomposed below 400°C, for full-surface attachment of non-mounted components on non-mounted electrical components.

## Revendications

1. Procédé de fabrication d'un composé électriquement conducteur ou à conductivité thermique pour le bonding de deux éléments, **caractérisé en ce que** de l'argent élémentaire est formé à partir d'un composé d'argent entre des faces de contact superposées.

2. Procédé selon la revendication 1, **caractérisé en ce que** le composé d'argent est un composé d'argent organique, de l'oxyde d'argent ou du carbonate d'argent.

3. Procédé selon la revendication 1 ou 2, **caractérisé en ce que** le composé d'argent organique est du lactate d'argent.

4. Procédé selon l'une quelconque des revendications 1 à 3, **caractérisé en ce qu'**une face de contact présente du métal commun à sa surface.

5. Procédé selon l'une quelconque des revendications 1 à 4, **caractérisé en ce que** la température de procédé pour la fabrication du bonding se situe en dessous de 400°C.

6. Procédé selon l'une quelconque des revendications 1 à 5, **caractérisé en ce qu'**une pâte qui présente le composé d'argent est appliquée sur une face de contact.

7. Procédé de fabrication d'un contact métallique sur toute la surface entre une face de raccord métallique d'un composant électronique et une face de raccord métallique d'un autre composant pour la fixation des composants l'un sur l'autre à une température en dessous de 400°C, selon l'une quelconque des revendications 1 à 6, **caractérisé en ce qu'**un contact métallique est en l'occurrence fabriqué, lequel se compose d'un métal qui ne fond qu'à plus de 400°C, **en ce qu'**un composé de ce métal ou d'un composant de celui-ci est décomposé en dessous de 400°C dans le métal ou un composant de celui-ci.

8. Procédé selon l'une quelconque des revendications 1 à 7, **caractérisé en ce que** le bonding de deux composants est la fixation
a) de corps de refroidissement ou de LED ou de DCB ou de cellules solaires ; ou
b) de semi-conducteurs de Si sur un substrat de Cu ; ou
c) en puce retournée ou empilement de boîtiers (PoP).

9. Utilisation d'une pâte de contact contenant un composé métallique décomposable en dessous de 400°C pour la fixation sur toute la surface de composants en vrac sur des composants électriques en vrac.
